# EUROPEAN PATENT SPECIFICATION

(11) **EP 1 222 972 B1**
(45) Date of publication and mention of the grant of the patent: **01.03.2006**
(21) Application number: 01205148.8
(22) Date of filing: 31.12.2001
(51) Int. Cl.: B08B 3/10, C23G 5/04

(54) **Machine and process for washing industrial articles**
Vorrichtung und Verfahren zur Reinigung von industriellen Artikeln
Machine et procédé de nettoyage pour des articles industriels

(30) Priority: 12.01.2001 IT PC010003
(43) Date of publication of application: 17.07.2002
(73) Proprietor: MEG S.a.s. di Ligugnana Ing. Giancarlo U., 36060 Romano d'Ezzelino (Vicenza) (IT)
(72) Inventor: Lugugnana, Giancarlo U., 36060 Romano d'Ezzelino (Vicenza) (IT)
(74) Representative: De Gregori, Antonella

(56) References cited:
- EP-A- 1 035 562
- WO-A-00/15359
- US-A- 5 113 883

## Description

The present invention relates to a machine for washing various industrial articles such as precision items, mechanical pieces, printed circuits, lenses, watchmaking, jeweler's, optical articles or others.

More specifically, the invention relates to a machine as claimed in claim 1.

The invention also relates to a method for washing industrial articles as claimed in claim 3.

The method and machine according to the invention enable washing to be effected in the cosolvent at a higher temperature than that allowed with current known machines, thus ensuring a more rapid and effective washing, but at the same time constantly operating under safety conditions.

Machines for washing industrial articles using a solvent and cosolvent are already known.

One of these known machines comprises, inside a closed structure, two tanks, the first containing a mixture of solvent and cosolvent, and the second a certain quantity of pure solvent.

Above these tanks there are cooling coils and the two tanks are connected by means of a weir which allows the solvent contained in the second tank to pass into the first.

The solvent used for rinsing generally consists of HFE (hydrofluoroether), whereas the cosolvent consists of a cleaning or degreasing agent of the type commonly used in the field.

As the cosolvent becomes flammable at a certain temperature, appropriate safety measures must be applied.

For this reason, in these known machines a part of the solvent is mixed with the cosolvent in the first tank. As the boiling point of the solvent is lower than that of the cosolvent (the former 55 degrees and the latter over 100 degrees), when the mixture is heated, the solvent, which is a non-flammable product, is the first to boil, creating a mass of vapour which protects the cosolvent contained in the tank.

The articles to be washed are then immersed in the tank containing the cosolvent mixture and are subsequently transferred to the second tank where they are rinsed in the pure solvent. At the end, the drum containing the articles is lifted and taken to the zone where there are the solvent vapours and cooling coils, for drying. The solvent vapours which are condensed are collected and, after passing through a water separator, are sent to the second tank, from which they overflow and partly fall into the first tank containing the mixture of the two components.

A second method, which uses cold cosolvent, comprises the use of a machine in which the two tanks are both filled with HFE, whereas unlike the previous method, the washing in the cosolvent takes place in a separate tank, optionally with mechanical stirring by means of a recirculation pump and/or ultrasounds. An apparatus for cleaning electronic components adopting said method is disclosed in EP 1035562-A2

This method, with respect to the previous one, involves the concentration of the contaminants in the separate tank.

In short, the drum containing the articles to be washed, after being immersed in the cosolvent in the separate tank, is introduced into the second zone of the machine to rinse the objects in the solvent.

At the end, the articles are dried in the vapour condensation zone and the recovered solvent is transferred to the second tank, again full of pure solvent, from which it overflows into the first.

In all these known methods, however, the temperature of the cosolvent must be kept at a level lower than the flash point, thus limiting the efficiency of the washing action of the product.

Furthermore, US-A-5113883 discloses an apparatus for cleaning objects having three compartments or tanks, each of them containing fluid solvents, such as a fluorocarbon-alcohol mixture; moreover, the temperatures of the solvents in each compartment may thus be selected in the range from ambient temperatures to boiling temperatures of the solvents.
It is therefore clear that the temperature of the liquid alcohol is limited by the boiling temperature of the solvent, thus also limiting washing action of products which may require higher temperatures.

This limitation is now overcome by the machine and method according to the invention, in which the distillation of the solvent, contained in the separate tank, generates a vapour zone above the free surface of the cosolvent, which consequently makes the product inert by eliminating the risks of flammability.

It is therefore possible to heat the cosolvent to a temperature which is even higher than the flash point, to obtain a more effective cleaning action thereof.

The present invention is now described in more detail, for illustrative but non-limiting purposes, with reference to the enclosed figures in which:

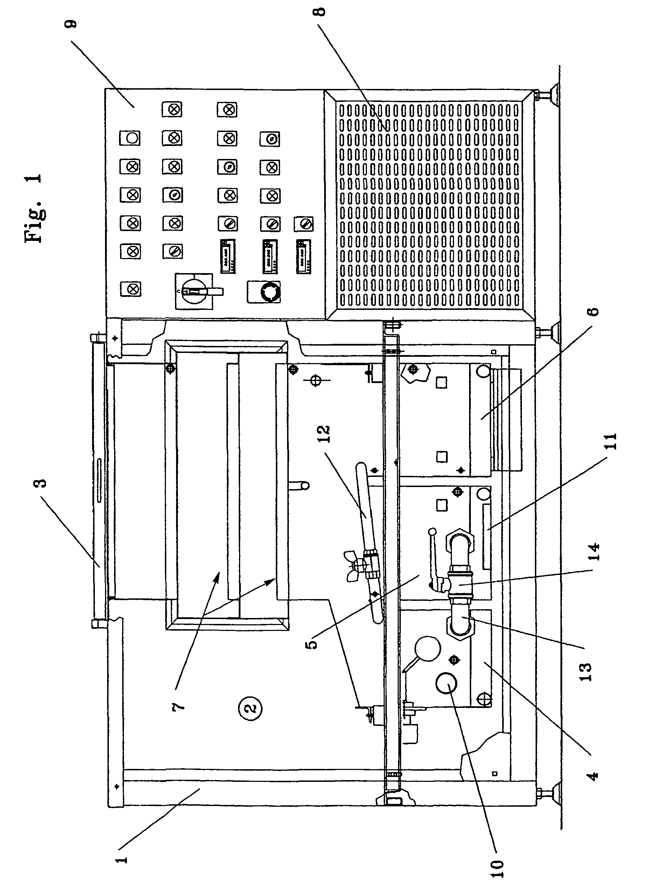

- figure 1 schematically illustrates a view of a machine according to the invention;

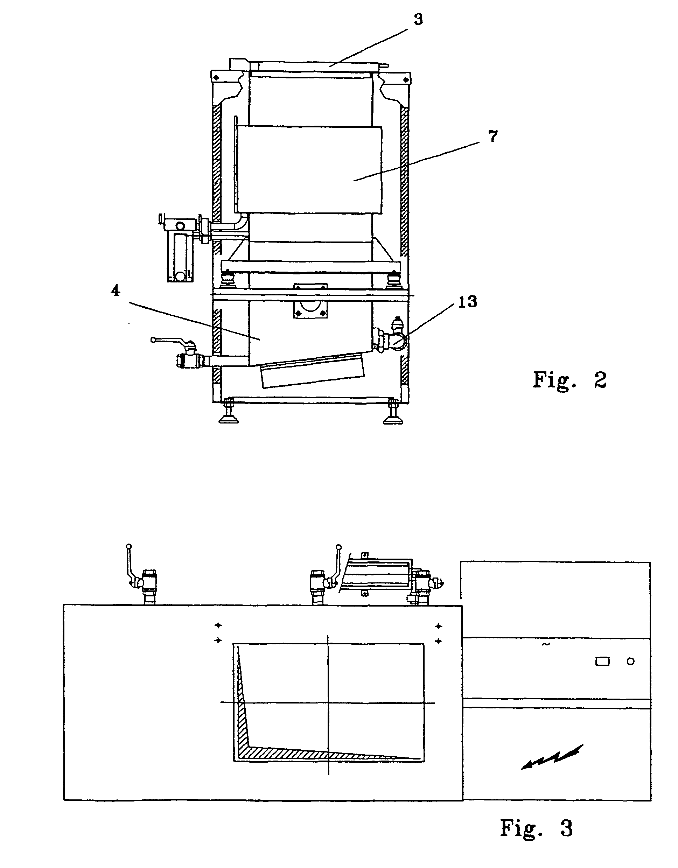

- figure 2 is the view of the machine of figure 1, in an orthogonal direction with respect to the previous one;
- figure 3 is the plan view of the machine according to the invention.

With reference to the enclosed figures, number 1 indicates the structure of the machine according to the invention, which defines an internal chamber 2 closed from above by a lid 3.

In the chamber 2 there are three tanks, respectively indicated with numbers 4, 5 and 6, containing the products for washing the articles.

Above the tanks there are cooling coils 7 connected to a cooling group 8 of the known type.

Number 9 indicates a panel with the machine controls, whose functions are driven by electronic devices of the known type, such as a PLC, for example.

The tank 4 contains a solvent, in particular HFE, and is equipped with heating devices of the known type, such as an electric resistance 10 or the like, capable of bringing the solvent to boiling point.

The central tank 5 contains a cosolvent of the type normally used for washing operations of industrial articles and is also equipped with a heating device of the known type, indicated with 11.

The third tank, indicated with 6, is filled with pure solvent (HFE), and is generally equipped with ultrasounds.

A duct 12 connects the upper part of the tank 6 with the tank 4, which is at a lower level so that the solvent of the tank 6 can pass, along the duct, into the tank 4.

The method according to the invention comprises the following operating phases:

The machine control devices firstly feed the resistance 11, to heat the cosolvent in the tank 5 to a temperature lower than the flash point.

The resistance 10 is subsequently fed to heat the solvent contained in the tank 4, to bring it to boiling point.

The HFE vapour (which, as already mentioned, forms an inertizing agent) is then generated, creating a vapour zone above said tanks.

The control devices again feed current to the resistance 11 to heat the cosolvent in the tank 5 to a temperature at which this product can exert its maximum washing efficiency, a temperature which can be higher than the flash point.

This is possible as safety conditions are maintained by the layer of inertizing vapours above the free surface of the cosolvent.

The drum containing the articles to be washed is immersed first in the tank 5 and, at the end, is passed into the tank 6 for rinsing in the solvent.

The drum is then lifted, left for a certain period of time in the zone above the tanks to continue the rinsing with the solvent vapours, and is then brought in correspondence with the cooling coils for drying.

The solvent which condenses in correspondence with the coils is collected in a gutter or other known devices, and is transferred again into the tank 6, after passing through a water separator of the known type.

When the solvent reaches the upper level of the tank, it passes through the duct 12 and the part in excess returns to the boiling tank 4, which is consequently constantly fed with pure solvent.

It is thus possible to obtain a rapid and effective washing of the articles, fully exploiting the characteristics of the products used and always operating under safety conditions.

The machine according to the invention can then also be used, when necessary, for effecting washings with the mixture of hot cosolvent, according to the known methods. For this purpose, a duct 13 is advantageously used, with a closing valve 14, which connects the two tanks 4 and 5.

In these tanks a mixture of solvent and cosolvent is therefore obtained, which makes it possible to operate with the two-tank method illustrated above in the description of the known art.

## Claims

1. Machine for washing industrial articles having bottom and side walls defining an internal chamber (2), said internal chamber (2) being subdivided into first (4), second (5) and third (6) tanks, each for containing products for washing said industrial articles, cooling coils (7), which are connected to a cooling group (8), being situated above said first (4), second (5) and third (6) tanks for condensing solvent vapours above said tanks (4, 5, 6), at least said first (4) and second (5) tanks being associated with respective first (10) and second (11) heating devices for heating said products for washing industrial articles, **characterised in that** said first tank (4) contains a solvent consisting of an inertizing agent and said first heating device (10) is powered for bringing said solvent to its boiling point, said second tank (5) contains a co-solvent and said second heating device (11) is powered for bringing said co-solvent to temperatures higher than its flash point, and said third tank (6) contains pure solvent, in which said articles are dried and rinsed, said third tank (6) being connected to said first tank (4) by means of a duct (12) for transferring solvent from said third tank (6) to said first tank (4), which is positioned at a lower level.

2. Machine for washing industrial articles as claimed in claim 1, **characterised in that** said second tank (5) is connected to said first tank (4) by means of a duct (13) with a closing valve (14) for mixing solvent and co-solvent.

3. Method for washing industrial articles by means of a machine as claimed in claim 1, **characterised in that** said method comprises the following phases:
- pre-heating said co-solvent contained in said second tank (5) to a value of temperature which is lower than the flash point of said co-solvent;
- heating said solvent contained in said first tank (4) to bring it to the boiling point for creating solvent vapours above said first tank (4);
- heating said co-solvent contained in said second tank (5) to a value of temperature which is higher than the flash point of said co-solvent;
- immersing said industrial articles to be washed in said co-solvent contained in said second tank (5);
- immersing said industrial articles in said solvent contained in said third tank (6) for rinsing;
- bringing said industrial articles above the tanks (4, 5, 6) for rinsing, by passing them through the solvent vapours;
- bringing said articles above the tanks (4, 5, 6) for drying, by passing them next to said cooling coils (7).

## Patentansprüche

1. Maschine zum Waschen industrieller Artikel mit Boden- und Seitenwänden, welche eine innere Kammer (2) definieren, wobei die innere Kammer (2) in einen ersten (4), zweiten (5) und dritten (6) Behälter unterteilt ist, jeweils zum Aufnehmen von Produkten zum Waschen der industriellen Artikel, wobei sich über dem ersten (4), zweiten (5) und dritten (6) Behälter mit einer Kühlgruppe (8) verbundene Kühlschlangen (7) zum Kondensieren von Lösungsmitteldämpfen über den Behältern (4, 5, 6) befinden, wobei zumindest der erste (4) und zweite (5) Behälter mit einer jeweiligen ersten (10) und zweiten Heizvorrichtung (11) zum Aufheizen der Produkte zum Waschen industrieller Artikel verbunden sind, **dadurch gekennzeichnet, dass** der erste Behälter (4) ein aus einem Inertisierungsmittel bestehendes Solvens enthält und die erste Heizvorrichtung mit Energie versorgt wird, um das Solvens auf dessen Siedepunkt zu bringen, wobei der zweite Behälter (5) ein Co-Solvens enthält und die zweite Heizvorrichtung (11) mit Energie versorgt wird, um das Co-Solvens auf Temperaturen über dessen Flammpunkt zu bringen, wobei der dritte Behälter (6) reines Solvens enthält, in welchem die Artikel getrocknet und gespült werden und wobei der dritte Behälter (6) mit dem ersten Behälter (4) mittels einer Leitung (12) zum Überführen von Solvens vom dritten Behälter (6) zum ersten Behälter (4), welcher auf einem niedrigeren Niveau angeordnet ist, verbunden ist.

2. Maschine zum Waschen industrieller Artikel nach Anspruch 1, **dadurch gekennzeichnet, dass** der zweite Behälter (5) mit dem ersten Behälter (4) mittels einer Leitung (13) mit einem Verschlussventil (14) zum Mischen von Solvens und Co-Solvens verbunden ist.

3. Verfahren zum Waschen industrieller Artikel mittels einer Maschine nach Anspruch 1, **dadurch gekennzeichnet, dass** das Verfahren folgende Phasen umfasst:
- Vorheizen des im zweiten Behälter (5) enthaltenen Co-Solvens auf einen Temperaturwert, welcher niedriger als der Flammpunkt des Co-Solvens ist;
- Aufheizen des im ersten Behälter (4) enthaltenen Solvens, um es auf den Siedepunkt zu bringen, um Solvensdämpfe über dem ersten Behälter (4) zu erzeugen;
- Aufheizen des im zweiten Behälter (5) enthaltenen Co-Solvens auf einen Temperaturwert, welcher höher als der Flammpunkt des Co-Solvens ist;
- Eintauchen der zu waschenden industriellen Artikel in das im zweiten Behälter (5) enthaltene Co-Solvens;
- Eintauchen der industriellen Artikel in das im dritten Behälter (6) enthaltene Solvens zum Spülen;
- Überführen der industriellen Artikel über die Behälter (4, 5, 6) zum Spülen, wobei diese durch die Solvensdämpfe geführt werden;
- Überführen der Artikel über die Behälter (4, 5, 6) zum Trocknen, wobei diese an den Kühlschlangen (7) vorbei geführt werden.

## Revendications

1. Machine pour laver des articles industriels ayant des parois inférieure et latérales définissant une chambre interne (2), ladite chambre interne (2) étant divisée en premier (4), second (5) et troisième (6) réservoirs, chacun pour contenir des produits afin de laver lesdits articles industriels, des serpentins de refroidissement (7) qui sont raccordés à un groupe de refroidissement (8), qui est situé au dessus desdits premier (4), second (5) et troisième (6) réservoirs pour condenser des vapeurs de solvant au dessus desdits réservoirs (4, 5, 6), au moins lesdits premier (4) et second (5) réservoirs étant associés avec des premier (10) et second (11) dispositifs de chauffage respectifs pour chauffer lesdits produits afin de laver des articles industriels, **caractérisée en ce que** ledit premier réservoir (4) contient un solvant se composant d'un agent d'inertage et ledit premier dispositif de chauffage (10) est actionné pour amener ledit solvant à son point d'ébullition, ledit second réservoir (5) contient un co-solvant et ledit second dispositif de chauffage (11) est actionné pour amener ledit co-solvant à des températures supérieures à son point d'éclair, et ledit troisième réservoir (6) contient du solvant pur, dans lequel lesdits articles sont séchés et rincés, ledit troisième réservoir (6) étant raccordé audit premier réservoir (4) au moyen d'un conduit (12) pour transférer le solvant dudit troisième réservoir (6) audit premier réservoir (4), qui est positionné à un niveau inférieur.

2. Machine pour laver des articles industriels selon la revendication 1, **caractérisée en ce que** ledit second réservoir (5) est raccordé audit premier réservoir (4) au moyen d'un conduit (13) avec un clapet de fermeture (14) pour mélanger le solvant et le co-solvant.

3. Procédé permettant de laver des articles industriels au moyen d'une machine selon la revendication 1, **caractérisé en ce que** ledit procédé comprend les étapes suivantes consistant à :
préchauffer ledit co-solvant contenu dans ledit second réservoir (5) à une valeur de température qui est inférieure au point d'éclair dudit co-solvant ;
chauffer ledit solvant contenu dans ledit premier réservoir (4) pour l'amener au point d'ébullition afin de créer des vapeurs de solvant au dessus dudit premier réservoir (4) ;
chauffer ledit co-solvant contenu dans ledit second réservoir (5) à une valeur de température qui est supérieure au point d'éclair dudit co-solvant ;
immerger lesdits articles industriels à laver dans ledit co-solvant contenu dans ledit second réservoir (5) ;
immerger lesdits articles industriels dans ledit solvant contenu dans ledit troisième réservoir (6) pour le rinçage ;
amener lesdits articles industriels au dessus des réservoirs (4, 5, 6) pour le rinçage, en les faisant passer par les vapeurs de solvant ;
amener lesdits articles au dessus des réservoirs (4, 5, 6) pour le séchage, en les faisant passer à proximité desdits serpentins de refroidissement (7).
